# EUROPEAN PATENT APPLICATION

(11) **EP 3 890 184 A1**
(43) Date of publication of application: **06.10.2021**
(21) Application number: 20168051.9
(22) Date of filing: 03.04.2020
(51) Int. Cl.: H02S 40/42

(54) **A HEAT SINK AND USES THEREOF**

(71) Applicant: The Provost, Fellows, Scholars and other Members of Board of Trinity College Dublin, Dublin 2 (IE)
(72) Inventor: MCCLOSKEY, David, Kilcock, Co. Kildare W23 D519 (IE)
(74) Representative: Purdylucey Intellectual Property

(57) **Abstract**

A heat sink for use with a photovoltaic solar panel unit having a top and a bottom, the heat sink comprising a plurality of fins spaced apart from each other and having a predetermined length, thickness and height.

## Description

### Field of the Invention

The invention relates to a heat sink and uses thereof. Specifically, the invention relates to a heat sink with a predetermined geometry that is suitable for use with photovoltaic solar panels.

### Background to the Invention

Modern, silicon-based photovoltaic solar panels can produce 20% efficiencies when tested under standard conditions of 1000W/m² at 25°C and are rated to last for 20 years. That is, for a given power of sunlight incident on the panel surface, 20% of this is converted to electricity. The other 80% is reflected or generates heat leading to significant temperature rises in the panel. In areas with high solar irradiance, and high air temperature, the panel temperature can exceed 100 °C. The immediate effect of this is to reduce panel efficiency due to temperature dependencies in the underlying physics, but also to accelerate natural degradation mechanisms which depend exponentially on temperature. In general, efficiency decreases by 0.5% for every degree the panel is above 25 °C. The panel lifetime depends on the average annual panel temperature, and halves for every 10 °C above 25 °C. Large temperature swings such as those seen in desert climates can also significantly accelerate panel degradation.

The long-term degradation of solar photovoltaic (PV) cells is well known in the industry and panel manufactures provide warrantees which include this degradation. This degradation rate can be up to 2% in the first two years, and then reduces approximately linearly at a slower rate. The rate of efficiency loss is known as the power coefficient β and for modern silicon solar cell designs is between 0.3-0.6% per annum or more depending on the cell technology and panel geometry. Ideally, after the agreed term -20 years, the panel should still be producing electricity at 80% of its rated efficiency. To achieve this the power coefficient should be less than 1%.

Twenty years is an extremely long time for a product to remain in service, and critical failure can occur due to a number of different effects, including but not limited to, water ingress, physical damage, sand abrasion, cementation, frame corrosion, back panel degradation, delamination, overheating, shading effects, short circuits, open circuits, damage of intra and inter cell connections. As such, extremely high-quality starting materials and manufacturing process must be used to guarantee efficiency over operational lifetime. Some companies focus on longevity of various components of the solar cell and solar panel construction. They produce conductive inks, adhesives and solar backplates with a focus on quality for extreme conditions. Elevated operating temperature has particularly adverse effects in arid, semi-arid and tropical environments where cell degradation can be significantly accelerated.

Previously proposed cooling technologies include natural air convection, forced air convection, natural fluid convection, forced fluid convection, spray cooling, radiative cooling, active cooling, and thermoelectric cooling. These cooling mechanisms come at additional energy or capital cost, or require large amounts of water, which is often scarce in arid areas in which solar is deployed.

WO 2018/117337 describes a solar cell cooling device that utilises both natural convective air flow and forced convective air flow through a series of spaced-apart fins having an air inlet and an air outlet. The problem with this device is that narrowing the space of the channel will increase airflow, but this is not an effective approach when using natural convection, as the geometry of the device will result in increased viscous drag and reduce the airflow rate.

CN204597884 describes a photovoltaic module junction box heat sink. The heat sink is made from aluminium, which is adhered to a heat conductive graphite paste. This patent refers to dissipating excess heat at the junction box only and does not relate to cooling the entire back section of a solar panel.

WO 2010/080204 describes a solar receiver (a base plate having a first surface and a second surface, a plurality of solar cells positioned over and supported by the first surface of the base plate) with a heat sink. The heat sink can be made from aluminium or copper and comprises a plurality of fins formed or fabricated from one continuous roll or sheet of material and bent to form a serpentine configuration. This heat sink refers to the application of concentrated photovoltaics (CPV), which is quite different to the PV geometry used in standard PV panels.

It is an object of the present invention to overcome at least one of the above-mentioned problems.

### Summary of the Invention

Due to the relatively low heat source density expected in photovoltaic solar panels (<2000 W/m²), and the large thermal resistance of the back plate, even a very low efficiency heat sink could have a significant effect on the steady state temperature. Previous works have taken passive natural convection heat sink designs from integrated electronics, and automotive applications, where relatively large heat source densities must be dissipated. They concluded that passive heat sinking of photovoltaic solar panels was not cost effective due to the quantity of aluminium required. One of the aims here is to show that, with the lower heat source density in solar panels, the inventors can use much less aluminium material, or even change material to polymers, or carbon-based materials for example. This will allow for better heat sink design and achieve a significant reduction in steady state operating temperature in a cost-effective manner. The inventors have identified that that conversion efficiency and panel lifetime can be significantly reduced when panels are deployed on sites depending on local climate. The efficiency and lifetime of photovoltaic solar panels are key parameters which directly affect the cost of photovoltaic solar panels. This determines its competitiveness and share in the energy mix, and ultimately the monetary and carbon footprint cost to each consumer.

The efficiency drop with increasing temperature is due to the temperature dependence of the bandgap of the semiconductor material. This temperature dependence is accounted for in the diode equation, which describes the electrical performance of the photovoltaic cell. Temperature dependence of efficiency is an important property regardless of the underlying solar cell technology and the invention described herein could be used with many photovoltaic technologies including but not limited to monocrystalline, polycrystalline and amorphous silicon, thin film cells, cadmium telluride, gallium arsenide, copper indium gallium selenide (CIGs), organic solar cells, perovskite solar cells, multifunction cells, dye sensitised solar cells, quantum dot solar cells, plasmonic and nanocrystal sensitised solar cells. This technology could also be used to improve the performance of electrochemical cells or fuel cells or thermoelectric generators.

There is provided, as set out in the appended claims, a heat sink for use with a photovoltaic solar panel unit having a top and a bottom, the heat sink comprising a plurality of fins spaced apart from each other and having a predetermined length, thickness and height, wherein the optimum fin spacing is between about 1 mm and about 50 mm. That is, between about 1, 2, 3, 4, 5, 6, 7, 8, 9, 10,11, 12, 13, 14, 15, 16, 17 18, 19, 20, 21, 22, 23, 24, 25, 26, 27, 28, 29, 30, 31, 32, 33, 34, 35, 36, 27, 38, 39, 40, 41, 42, 43, 44, 45, 46, 47, 48, 49 and 50 mm, and any value individually mentioned here..

In one aspect, the height of the plurality of fins increases in the direction towards the top of the solar panel unit.

In one aspect, the fins have a thickness of between about 0.01 mm to about 1 mm. That is, between about 0.01, 0.02, 0.03, 0.04, 0.05, 0.06, 0.07, 0.08, 0.09, 0.10, 0.15, 0.20, 0.25, 0.30, 0.35, 0.40, 0.45, 0.50, 0.55, 0.60, 0.65 0.70, 0.75, 0.80, 0.85, 0.90, 0.95, and 1.00 mm, and any value individually mentioned here..

In one aspect, the fins have a height at the bottom of the photovoltaic solar panel unit of between about 0.5 cm to about 10 cm. That is, between about 0.5, 1.0, 1.5, 2.0, 2.5, 3.0, 3.5, 4.0, 4.5, 5.0, 5.5, 6.0, 6.5, 7.0, 7.5, 8.0, 8.5, 9.0, 9.5 and 10 cm, and any value individually mentioned here..

In one aspect, the fins have a length of between about 10 mm to about 1500 mm. That is, between about 10, 15, 20, 25, 30, 35, 40, 45, 50, 55, 60, 65, 70, 75, 80, 85, 90, 95, 100, 150, 200, 250, 300, 350, 400, 450, 500, 550, 600, 650, 700, 750, 800, 850, 900, 950, 1000, 1050, 1100, 1150, 1200, 1250, 1300, 1350, 1400, 1450, and 1500 mm, , and any value individually mentioned here..

In one aspect, the spacing of the fins is between about 0.5 cm to about.5 cm. That is, between about 0.5, 0.75, 1.0, 1.25, 1.5, 1.75, 2.0, 2.25, 2.5, 2.75, 3.0, 3.25, 3.5, 3.75, 4.0, 4.25, 4.5, 4.75, and 5.0 cm, and any value individually mentioned here.

In one aspect, the fins are composed of thermally conductive films selected from the group comprising metallic film, a carbon-based film, or polymer films doped with conductive particles or a combination thereof. Preferably, the metallic films are selected from films comprising aluminium, copper, stainless steel, tungsten, titanium, or combinations thereof. Preferably, the carbon-based films are selected from films comprising graphite, pyrolytic graphite, synthetic graphite, graphene or carbon nanotubes, expanded graphite, graphite composites, carbon black, diamond, or combinations thereof. Preferably, the conductive particles in the polymer films are selected from a diamond, carbon, transition metal nitrides such as AlN, transition metal oxides such as AlO₃, ceramics such as Si₃N₄, BN or SiC or combinations thereof.

In one aspect, the plurality of fins are flexible.

In one aspect, the plurality of fins are coated with an epoxy, a copolymer or a polymer. Preferably, the polymer or copolymer is selected from an elastomer, a thermoplastic, a thermoset, a biopolymer, or a combination thereof.

In one aspect, the polymer is a thermoplastic which may be selected from, but not limited to, the group comprising acrylonitrile butadiene styrene, polypropylene, polyethylene, polyvinylchloride, polyamide, polyester, acrylic, polyacrylic, polyacrylonitrile, polycarbonate, ethylene-vinyl acetate, ethylene vinyl alcohol, polytetrafluoroethylene, ethylene chlorotrifluoroethylene, ethylene tetrafluoroethylene, liquid crystal polymer, polybutadiene, polychlorotrifluoroehtylene, polystyrene, polyurethane, and polyvinyl acetate.

In one aspect, the polymer is a thermoset which may be selected from, but not limited to, the group comprising vulcanised rubber, Bakelite (polyoxybenzylmethylenglycolanhydride), urea-formaldehyde foam, melamine resin, polyester resin, epoxy resin, polyimides, cyanate esters or polycyanurates, silicone, and the like known to the skilled person.

In one aspect, the polymer is an elastomer which may be selected from, but not limited to, the group comprising polybutadiene, butadiene and acrylonitrile copolymers (NBR), natural and synthetic rubber, polyesteramide, chloropene rubbers, poly(styrene-b-butadiene) copolymers, polysiloxanes (such as Polydimethylsiloxane (PDMS)), polyisoprene, polyurethane, polychloroprene, chlorinated polyethylene, polyester/ether urethane, poly ethylene propylene, chlorosulphanated polyethylene, polyalkylene oxide and mixtures thereof.

In one aspect, the polymer is a biopolymer which may be selected from, but not limited to, the group comprising gelatin, lignin, cellulose, polyalkylene esters, polyvinyl alcohol, polyamide esters, polyalkylene esters, polyanhydrides, polylactide (PLA) and its copolymers and polyhydroxyalkanoate (PHA).

In one aspect, the polymer is a copolymer selected from, but not limited to, the group comprising copolymers of propylene and ethylene, acetal copolymers (Polyoxymethylenes), polymethylpentene copolymer (PMP), amorphous copolyester (PETG), acrylic and acrylate copolymers, polycarbonate (PC) copolymer, styrene block copolymers (SBCs) to include poly(styrene-butadiene-styrene) (SBS), poly(styreneisoprene-styrene) (SIS), poly(styrene-ethylene/butylene-styrene) (SEBS), ethylene vinyl acetate (EVA) and ethylene vinyl alcohol copolymer (EVOH) amongst others.

In one aspect, the fins are made from one continuous sheet of material, or wherein one or more of the plurality of fins are composed of two or more different sheets of material. Preferably, one or more of the plurality of fins can be uniform or varied in composition.

In one aspect, the plurality of fins are applied to the solar panel as a singular unit, or as a series of segmented units.

In one aspect, the air flow through the heat sink is by forced, natural, or passive convection.

In one aspect, the plurality of fins further comprises a support base. Preferably the support base is mounted individually to each fin. Ideally, the support base is mounted to two or more fins.

In one aspect, the support base is opaque, transparent, or a combination thereof.

In one aspect, the fins have a cross-sectional shape selected from a trapezoid, a sinusoid, a triangle, free-flowing, a square, a circle, a pentagon, a parallelogram, a kite, a crescent, a trefoil, a chevron, a cross, an equiangular shape, columnar, an oblong, an oval, a teardrop, a medallion, a star, a diamond.

In one aspect, the plurality of fins are attached to the solar panel unit with an adhesive or by a friction fit with a frame of the solar panel unit.

In one aspect, the heat sink further comprises a top support.

In one aspect, the heat sink further comprises an airflow isolation means across the width of the plurality of fins.

In one aspect, the heat sink further comprises a base plate. Preferably, the base plate is made from a metal such as aluminium, stainless steel, titanium, copper, tungsten or alloys including these materials. Ideally, the base plate is made from a white or transparent material selected from glass, diamond, polymer, quartz, oxides and nitrides of transition metals such as aluminium nitride, aluminium oxide, Titanium Dioxide, and the like.

In one aspect, there is provided a method of producing a heat sink as described above, the method comprising the steps of forging, extruding, die casting or machining the plurality of fins.

In one aspect, the fins are forged, extruded, die cast or machined from a single piece of material.

In one aspect, the plurality of fins are forged, extruded, die cast or machined individually.

In one aspect, there is provided a photovoltaic solar panel geometry comprising the heat sink described above.

In one aspect, the photovoltaic solar panel is bifacial or monofacial.

In one aspect, there is provided a back plate for a photovoltaic solar panel which includes the heat sink design.

### Definitions

In the specification, the term "heat sink" should be understood to mean a passive heat exchanger that transfers the heat generated by an electronic or a mechanical device to a fluid medium, often air or a liquid coolant, where it is dissipated away from the device, thereby allowing regulation of the device's temperature at optimal levels. The heat sink may operate using conduction, convention or radiative heat transfer, or a combination of these mechanisms.

In the specification, the term "solar panel" or "solar photovoltaic (PV) panels or systems" are interchangeable terms that should be understood to mean an assembly of photovoltaic cells mounted in a framework for installation. Photovoltaic cells use sunlight as a source of energy and generate direct current electricity. A collection of PV cells is called a PV Panel, and a system of Panels is an Array. Arrays of a photovoltaic system supply solar electricity to electrical equipment. Solar panels can be unifacial or monofacial (accepting light from one side only) or bifacial (accepting light from both sides).

In the specification, the term "natural convection", "passive convection", or "free convection" should be understood to mean a mechanism, or type of mass and heat transport, in which the fluid motion of air is generated only by density differences in the fluid occurring due to temperature gradients, not by any external source (like a pump, fan, suction device, *etc.*)*.* The driving force for natural convection is gravity. The terms can be used interchangeably.

In the specification, the term "forced convection" should be understood to mean a mechanism in which the fluid motion of air is generated by an external source such as a pump, a fan, a suction device, or wind *etc.*

In the specification, the term "base plate" should be understood to mean a plate which supports the fins to stand in a fixed direction. The base plate can be continuous connecting all the fins or can be separate for each individual fin. The base plate can be made from metal such as aluminium, or transparent materials such as glass or polymer, and the like.

In the specification, the term "solar panel mounting system" or "photovoltaic mounting systems" should be understood to mean a system of support structures which allow the panel to be mounted on a pitched roof, mounted on a flat roof, mounted on a wall. mounted on a pole, ground mounted, or mounted on floating platform.

In the specification, the term "segmented" should be understood to mean where a plurality of fins attached to, for example, the back of a photovoltaic solar panel are adhered in a series of segments rather than in a single block of fins.

In the specification, the term "top support" should be understood to mean a support placed on the upper peak of the plurality of fins. The top support may be made from the same material as the fins or a different material and is to provide mechanical stability.

In the specification, the term "an airflow isolation means" should be understood to mean a method of keeping air separate in each of the sections of fins to avoid mutual heat exchange between sections.

The term "polymer" in the specification should be understood to mean a large molecule (macromolecule) composed of repeating structural units. These subunits are typically connected by covalent chemical bonds. Although the term "polymer" is sometimes taken to refer to plastics, it actually encompasses a large class comprising both natural and synthetic materials with a wide variety of properties. Such polymers may be thermoplastics, elastomers, or biopolymers.

The term "copolymer" should be understood to mean a polymer derived from two (or more) monomeric species, for example a combination of any two of the below-mentioned polymers. An example of a copolymer, but not limited to such, is PETG (Polyethylene Terephthalate Glycol), which is a PET modified by copolymerization. PETG is a clear amorphous thermoplastic that can be injection moulded or sheet extruded and has superior barrier performance used in the container industry.

The term "thermoset" should be understood to mean materials that are made by polymers joined together by chemical bonds, acquiring a highly cross-linked polymer structure. The highly cross-linked structure produced by chemical bonds in thermoset materials is directly responsible for the high mechanical and physical strength when compared with thermoplastics or elastomers materials.

The invention described herein does not accelerate airflow like some of the heat sink designs of the prior art. The invention described herein illustrates that increasing the height of a plurality of fins from the bottom to the top of the solar panel will help to create more uniform cooling. This is precisely the opposite direction of tapering as claimed in some prior art documents.

The invention described herein applies to standard solar photovoltaic panels (PV). Standard PV generates much lower heat flux and it is not obvious that heat sinking would work well in this situation. Furthermore, the optimum fin design in relation to spacing and height will be different in the case of PV than for CPV.

### Brief Description of the Drawings

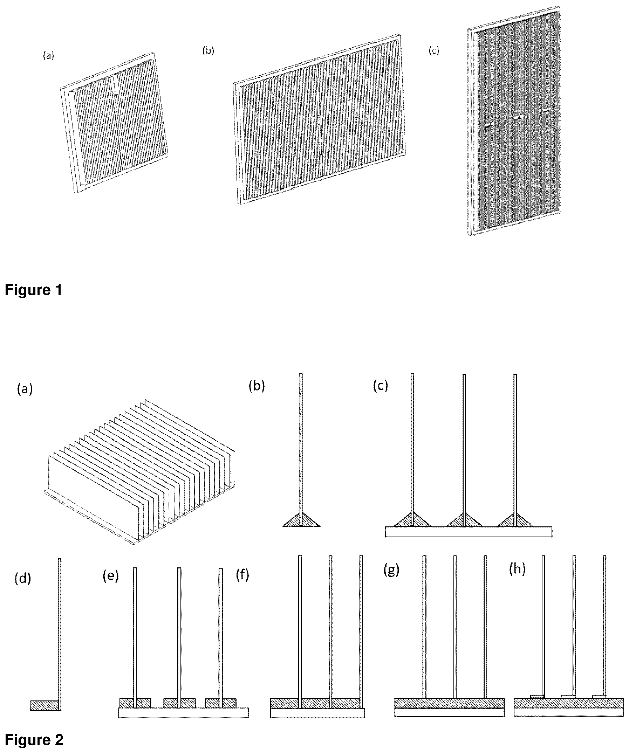

The invention will be more clearly understood from the following description of an embodiment thereof, given by way of example only, with reference to the accompanying drawings, in which:-
**Figure 1(a)****-(c)** illustrates an embodiment of the invention with a parallel aluminium fin design. Fins are made from 0.5 mm thick aluminium sheet, having a height of 5 cm and spaced apart by 1 cm. In Figure1 (a) there are 49 fins spread across a typical 50W solar panel. In Figure1 (b) the fins are shown on a typical 320Wp panel designed to be mounted horizontally. Figure 1(c) shows a 320Wp panel designed to be mounted vertically. The fins should always be orientated vertically with respect to gravity.
**Figure.2(a)****-(h) (a)** illustrates isometric view of vertical fins; **(b)** illustrates an example of a single fin with triangular support; **(c)** illustrates an example of individual fins on a panel (white rectangle); **(d)** illustrates an example of a single fin with a rectangular base; **(e)** illustrates an example of fins mounted individually with a rectangular base; **(f)** illustrates an example of fins with a rectangular base made into continuous base plate; **(g)** illustrates fins mounted on a separate base plate; and **(h)** illustrates fins bent at the bottom to attach to a base plate.

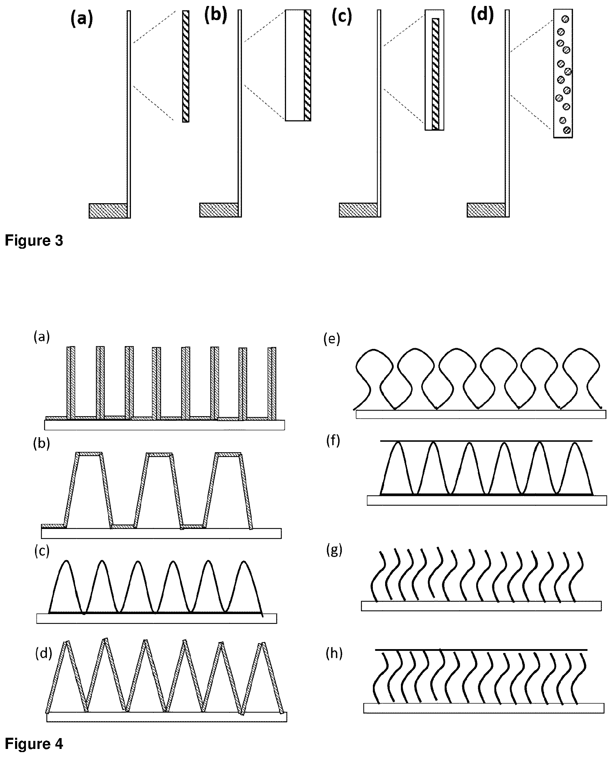

**Figure 3(a)****-(d)** illustrates examples of fin materials and layer structures. **(a)** is a single material fin with base; **(b)** is a high thermal conductivity thin fin material with a support material; **(c)** is a high thermal conductivity fin material encapsulated in a support material; and **(d)** is a high thermal conductivity material included as particles in a support material.
**Figure 4(a)****-(h)** shows examples of possible cross-sectional fin shapes made from a single or segmented sheet. **(a)** is a single fin structure, which can be made from folding a single sheet, or from individual sections. Fins coupled could be vertical or at an angle; **(b)** shows a trapezoidal cross section to enhance contact area; **(c)** shows a sinusoidal cross section; **(d)** shows free standing and flexible fins; **(e)** shows a sinusoidal with top support and a base; **(f)** shows a triangular shape; **(g)** shows a fin shape defined naturally when one folds a thin film; and **(h)** shows a free standing fin with a top support.

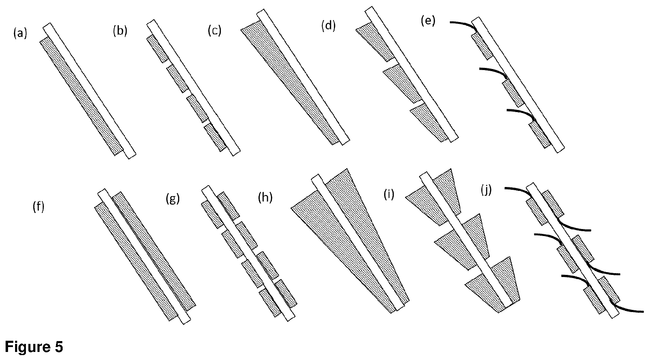

**Figure 5(a)****-(j)** illustrate fin geometry alternates in profile attached to a panel (white rectangle) **(a-e)** shows back of panel attachments; **(f-j)** show both back and front of panel attachments. **(a)** is a single continuous fin; **(b)** is a plurality of segmented fins; **(c)** is a single fin with varying height; **(d)** is a plurality of segmented fin with varying height; **(e)** is a plurality of segmented fins with structures to isolate airflow across each section. **(f(-(j)** Same designs as shows in (a)-(e) but with the heat sink of the claimed invention on the front surface of the panel. The heat sinks shown here could be made of highly reflective or transparent materials.

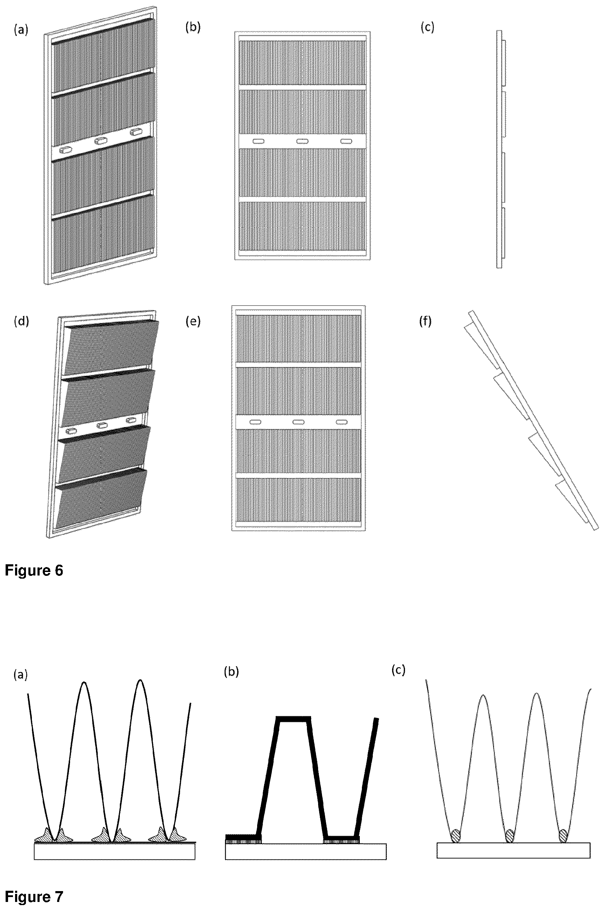

**Figure 6(a)****-(f)** show back view of various embodiments of the heat sink of the claimed invention. **(a)** shows a perspective view of a standard single continuous fin along the length of a panel; **(b)** shows a plan view of segmented fins of the claimed invention positioned on the panel to disrupt airflow; **(c)** shows a plurality of segmented fins with offsets between sections to disrupt airflow; **(d)** shows a plurality of segmented fins with different pitches or heights in each section of the panel; and **(e)** shows a side view of the plurality of segmented fins from (d) with structures to isolate airflow between sections.
**Figure 7(a)****-(c)** are examples of fin adhesion alternates. **(a)** shows that fins can be attached directly to the back of a panel or a backplate using adhesive or the like; **(b)** shows that different geometries can be used to increase the surface area of contact between the fin and the panel/backplate to reduce thermal resistance; **(c)** shows that fins could be attached without adhesive using external pressure from mounting to the panel frame or the like.

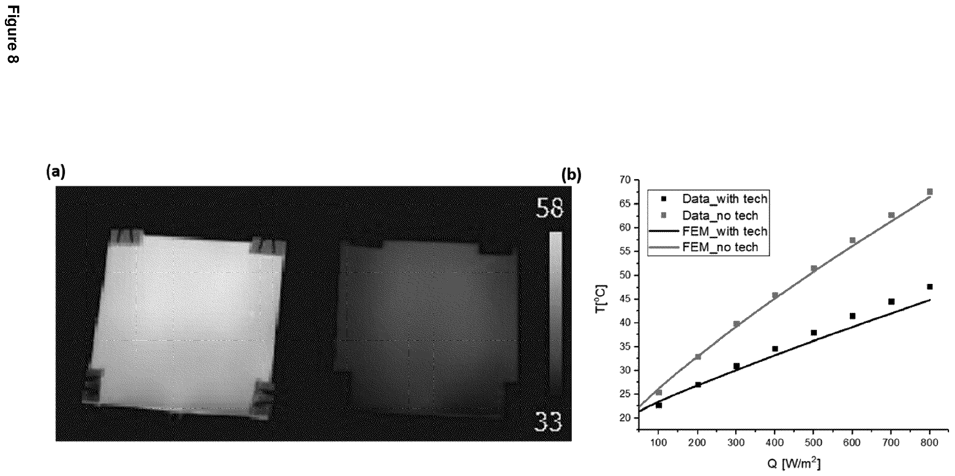

**Figure 8 (a)** is an IR image of a 17cm x 17cm single cell-sized panel mounted at 45°. The left-hand side of the image is a panel with no heat sink, while the right-hand side of the image is a panel with a 0.5mm aluminium heat sink. **Figure 8(b)** is a graph showing the scaling of cell temperature with heat source power (proportional to solar irradiation). The solid line is a finite element method (FEM) simulation, while the data points are experimental measurements from the test panel.

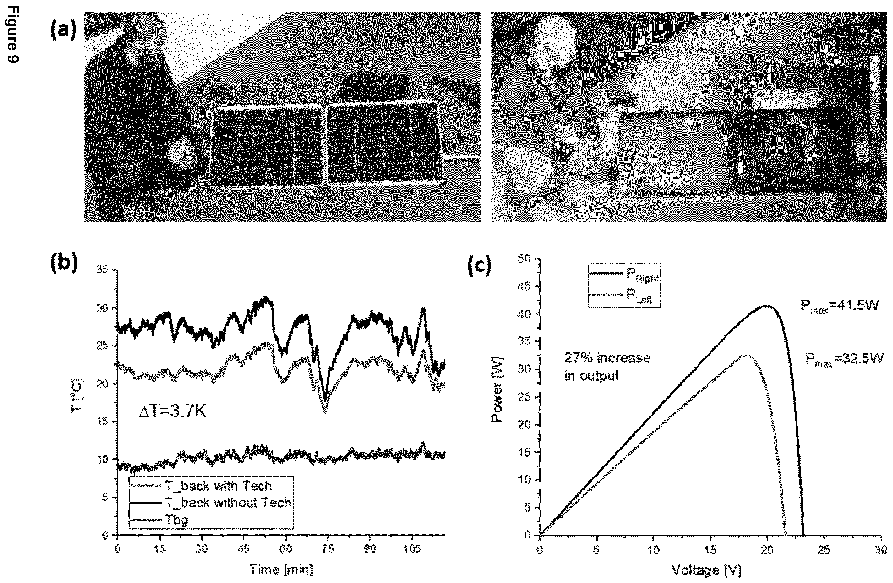

**Figure 9(a)** shows the visible and IR images of an outdoor test using two identical 50W panels. The right-hand panel is modified on its back surface with a heat sink of the claimed invention. **Figure 9(b)** is a graph showing the temperatures over a 2-hour period measured at the back surface of a panel with the heat sink of the claimed invention. Max ΔT=3.7°C. **Figure 9(c)** is a graph showing experimentally measured power curves using the PV test instrument shown in Figure 9(a). Max power output is increased by 27% in this case. Background temperature was 10°C and incident irradiance was 400W/m².

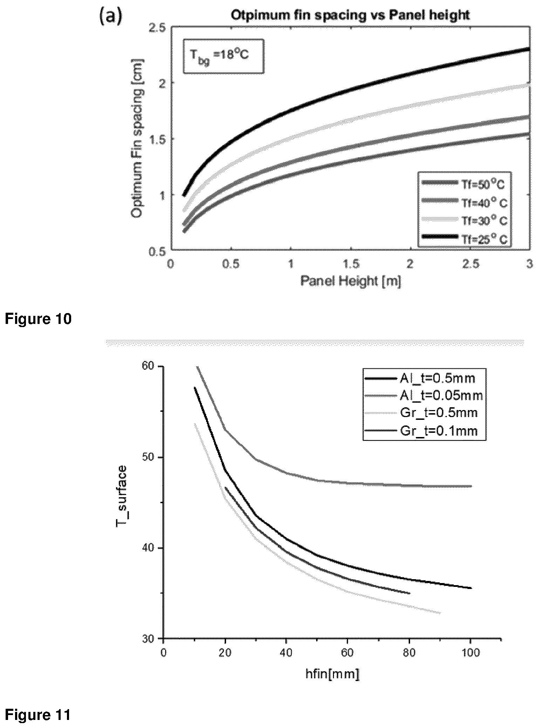

**Figure 10** illustrates the optimum fin spacing vs panel height for different fin temperatures calculated analytically.
**Figure 11** is a graph illustrating the solar cell temperature as a function of fin height for different materials and thicknesses of a heat sink of the claimed invention.

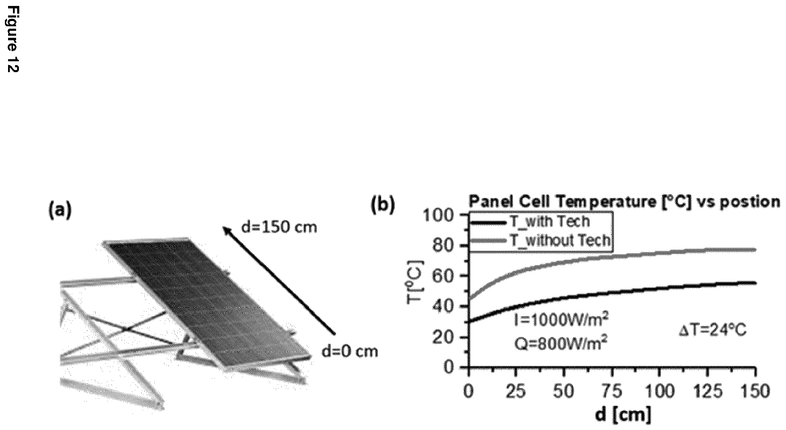

**Figure 12** illustrates **(a)** a schematic of a panel in a typical ground mount at 45°; and **(b)** a graph illustrating the panel cell temperature under 1 sun illumination (1000W/m²) without a heat sink (red/top curve) and with the heat sink of the claimed invention (black/bottom curve).

### Detailed Description of the Drawings

The inventors propose using thermally conductive films such as metallic films, carbon-based films, or polymer films doped with conductive particles to create a novel heat sink. Combinations of these films could also be used. These materials can be manufactured on a large-scale using extrusion and/or roll-to-roll processing. Pyrolytic graphite film, for example, is very low density (1.9 g/cm³) and has extremely high thermal conductivity (1950 W/m/K), 9.5-times that of aluminium. Currently, it is primarily used as a heat spreader in electronic devices. Because of its high thermal conductivity, much thinner layers can be used as compared to aluminium which significantly reduces weight and material cost. The graphite used can be either synthetic or natural (mined from the ground). It is processed into a roll which allows for efficient transport. It can be purchased in large quantities from manufacturers.

The heat sink of the claimed invention can use an origami-inspired approach to create novel high-surface area heat sink designs from the film starter material. This heat sink can be attached directly to the backplate of a solar panel or attached to a photovoltaic solar panel frame as shown in **Figure 1****.** Examples of a simple straight fin geometry are shown applied to a 50W panel in **Figure 1(a)****,** and a standard 320W panel in **Figure 1****(b-c).** **Figure 1(b)** shows the fin orientation when the panel is intended to be mounted in a landscape orientation. **Figure 1(c)** shows the case when the panel is intended to be mounted in a portrait orientation. The fins should always be aligned with gravity so that natural convection work effectively.

The heat sink can be constructed from individual fins which are assembled as shown in **Figure 2(a)****.** This consists of individually mounted fins as shown in **Figure 2(b)** mounted as shown in **Figure 2(c)****.** In this case, a triangular base mount is used. This may attach the fin directly to the back of the panel or to a baseplate. In **Figure 2(d)** an alternative rectangular base mount is shown. They may be mounted separately as shown in **Figure 2(e)** or combined into a single unit before application, such as in **Figure 2(f)****.** Alternatively, the fins may be attached to a single baseplate as shown in **Figure 2(g)****.** The fins may be folded to attach to the back of the panel, or the baseplate as shown in **Figure 2(h)****.** These base mounts and baseplates can be made from the same material as the fin or from a different material. They can be transparent or opaque and made from metal, polymer, or glass, or a combination to these. They may be matched to the thermal expansion coefficient of the backplate, solar glass or other photovoltaic solar panel material.

The fins may be made from a single high thermal conductivity material as shown in **Figure 3(a)** or may be made from a high thermal conductivity material adhered to a supporting material as shown in **Figure 3(b)****.** They may be made from a continuous high thermal conductivity material encapsulated in a supporting material, as shown in **Figure 3(c)****,** or a discontinuous high thermal conductivity material dispersed in a supporting material, as shown in **Figure 3(d)****.**

In one embodiment, the heat sink structure can be created from a single film or material, or from multiple sections. These films may have the structures described in **Figure 3****.** By creating bends and folds in the design, different heat sinks can be created by periodically adhering the film to the back of the panel or the baseplate. Some representative cross sections are shown in **Figure 4(a)****-(h).** The thermal resistance of the heat sink can be tuned to match the solar panel design by choosing a material with a particular thermal conductivity **κ**, a film thickness **t,** a height of the film **h,** and a periodicity **A.** The heat sinks can be constructed in a way to create rigid structures, with some cross-section examples shown as plate fins in **Figure 4(a)****,** as trapezoidal in **Figure 4(b)****,** as sinusoidal in **Figure 4(c)** and as triangular in **Figure 4(d)****.** Some films may form naturally into a shape similar to that shown in **Figure 4(e)****.** A supporting top structure can be applied to any of the cross sections to improve mechanical stability, as shown with the sinusoidal cross section in **Figure 4(f)****.** The heat sink could also be left to hang flexibly, as depicted in **Figure 4(g)** and **Figure 4(h)** Free moving structures have the advantage of moving with the wind, which would enhance heat transfer through forced convection and turbulence. The heat sinks of the claimed invention do not need to be periodic or ordered. They may have sinusoidal, triangular, undulating, square, rectangular or fractal cross sections. When they are periodic, they can have multiple periodicities or vary depending on the position the heat sink of the claimed invention takes on the panel.

Side views of embodiments of the invention are shown in **Figures 5(a)****-(j).** The fin structures may be continuous along the entire panel length or applied in sections as shown in **Figure 5(a)** and **Figure 5(b)****,** respectively. Examples are shown with 3-4 sections, however there may be any number of sections as the user sees fit. The fin height may vary as a function of panel position. An example of a linear variation is shown in **Figure 5(c)****,** and in the segmented design in **Figure 5(d)****.** An additional structure could be used to separate airflow from each of the sections, as indicated by the black line in **Figure 5(e)****.** For some panels, such as bifacial panels, transparent base plates and fins, or highly reflective fins, are typically used. It would be possible to use these heat sinks on the front surface of the panel also. The same concepts are shown both on front and back of panel in **Figure 5(f)****-(j).**

photovoltaic solar panels are mounted at an angle to optimise solar irradiation. Shallow angles may cause issues for natural convection, with air getting trapped beneath the panel. The design may require modification of the top and bottom parts of the frame holding the panel to allow air to flow across the heatsink surface. The heatsinks could be segmented, or the length of the heat sink could be varied depending on position on the panel to optimise natural convection heat transfer, and to ensure uniform cooling. The heatsinks could be mounted as strips with gaps between these to allow airflow to move through. The heat sink may be long enough to protrude from the back of the panel surface, or it may be short enough to be completely hidden by the panel frame. Full back panel views of segmented fins are shown in **Figure 6****.** Simple parallel rectangular fins are shown. These fins may be made from any of the materials or layer structures outlined in **Figure 3****.** They may have other cross sections, such as those outlined in **Figure 4****.** They may have any number of different types of sections, as shown in **Figure 5****.** **Figure 6(a)****-(c)** shows isometric, back and side views of an example of a 320Wp solar panel with simple rectangular fins. **Figure 6(d)****-(f)** shows isometric, back and side views of a segmented design with tapered fins. A simple linear, tapered design is shown, however other tapered designs could be used. In segmented designs, sections may have different fin height, periodicity and thickness. Sections may be made of different materials. Sections may be offset to disrupt airflow between each segment.

Good adhesion between the heat sink and the photovoltaic solar panel and the fin structure and base is very important to ensure good thermal contact. There are several commercially available glues and epoxies that can be used. **Figure 7** outlines some example adhesion techniques. **Figure 7(a)** shows adhesion using glue with a sinusoidal cross section design. Designs such as trapezoidal cross section may allow larger contact area and better thermal contact as shown in **Figure 7(b)****.** The heatsink may be attached without using glue, just by applying pressure against the frame. Bars could be used to evenly apply the pressure as shown in cross section in **Figure 7(c)****.**

An alternative would be to mechanically fix the heat sink to the backplate using various securing means such as a nail, a screw, a tack, snap-fit configuration, adhesive, and the like. A combination of both techniques could be used. The contact area should be controlled in order to tune the thermal resistance of the heat sink and ensure uniform cooling.

To demonstrate the performance of the heat sink of the claimed invention, the inventors created a test rig where heater pads were inserted in a standard solar panel geometry, which allowed precise control of the heat source while monitoring cell temperature, surface glass temperature, and the heat flux through the back surface of the panel. **Figure 8(a)** shows IR thermal images of the front of the test bed. The panel on the left has no heat sink, whereas the panel on the right has an aluminium heat sink with a fin thickness of 0.5 mm. To test performance under different conditions, the current in the heater pad is controlled such that the heat source density changes from 100W/m² to 800W/m². **Figure 8(b)** shows the resulting solar cell temperature measured experimentally (data points) and predicted using numerical simulations (solid line).

The inventors also compared the performance of two identical monocrystalline 50W solar panels with and without the heat sink of the claimed invention. The panels were placed outdoors in realistic weather conditions at the beginning of March in Ireland (see **Figure 9(a)****-(c)**). Maximum solar irradiance was measured at 600W/m² and the background temperature was 10°C. The backside of the panel with no technology reached 30°C, whereas the backside temperature with the technology remained below 25°C. Even with a small change in temperature, a significant increase of 27% in output power from the panel with the heat sink of the claimed invention was observed.

The inventors performed extensive analytical and numerical studies to optimise the design. **Figure 10** illustrates the relationship between the optimum fin spacing and the panel height at various temperatures, calculated using analytical theory. The optimum spacing depends on aspect ratio and the expected fin operating temperature.

The optimum fin height and thickness are calculated using numerical FEM simulations. In **Figure 11****,** it is shown that for the aluminium foil (a thickness of 0.05mm) there is a reduced benefit in increasing the fin height past 50 mm. This is because the thermal resistance is large and the thermal gradient along the fin height is significant. Increasing the height of the fin beyond this has minimal effect because the temperature difference between the fin and the air is too low to exchange a reasonable amount of heat. For the thicker aluminium sheet (0.5 mm) there are benefits out to 10 cm, however this will add additional cost and weight to the device.

### Materials and Methods

### Solar Panel construction

A typical layout of a photovoltaic solar panel is a layer of glass, a first encapsulant layer, a solar cell, a second encapsulant layer, and a back sheet. The glass is low iron tempered glass and usually between 2.8-4 mm thick. It provides the main structural support for the solar cells, which are extremely thin and brittle. The encapsulant is usually a form of ethylene-vinyl acetate (EVA) optimized to withstand prolonged UV exposure. The back sheet can be made of polyethylene terephthalate (PET), polyvinylidene fluoride (PVDF), or propriety materials such as DuPont™ Tedlar® (a polyvinyl fluoride film). These materials must protect the cells from moisture ingress and temperature cycling.

### Heat sink materials

The proposed heat sink can be made from any material with high thermal conductivity (>50W/m/K). In particular, the inventors have demonstrated the heat sink of the claimed invention using aluminium and expanded graphite. The high thermal conductivity material may be supported or encapsulated by a low thermal conductivity material in geometries as depicted in **Figure 3****.** Metals including but not limited to aluminium, copper, stainless steel, titanium and alloys containing these elements. Carbon-based materials including but not limited to graphite, pyrolytic graphite, expanded graphite, diamond, carbon filler, carbon nanotubes, graphene are of particular interest due to low density, high thermal conductivity and high IR emissivity. Other high thermal conductivity materials such as aluminium nitride, silicon nitride and boron nitride are of interest.

### Heat sink Testing

To reproduce the effects of heating due to solar irradiation of a solar panel in a quantitative and reproducible fashion, the inventors devised a simple rig with a silicone heating mat in place of a silicon solar cell. A glass front panel and a polycarbonate back panel were cut to area 17cm x 17cm. The glass was 2.8mm thick and the PC panel was 1.5 mm thick. A heating mat was used with an input voltage of 12V, and maximum power dissipation of 15W. This permitted the inventors to get up to 800 W/m² as a heat source density, which is enough to represent solar panels under standard test conditions. A thermal image of the front surface (glass) is shown of the device without and with the heat sink on left and right-hand sides respectively in **Figure 8(a)****.** The image is taken with a heat source density of 800 W/m² .The current was controlled to sweep the heat source density from 100 W/m² to 800 W/m² and the cell temperature was monitored with and embedded thermocouple for the cases with and without the heat sink. The results are shown in **Figure 8(b)****.** The experimental measurements are shown as data points, whereas the solid lines represent the prediction of numerical models performed using the 3D finite element method. In extreme environments, panels could experience peak heat source densities of 1920 W/m². A higher power heating mat is required to simulate these conditions.

As a further demonstration a standard 50W photovoltaic solar panel was fitted with a heat sink made using a 0.5mm aluminium sheet. Individual fins were adhered to the back of the solar panel without the use of a back plate to reduce cost. **Figure 9(a)** shows visible and thermal images of the device of the claimed invention in outdoor conditions under 600W/m² solar irradiance. The panel on the right is fitted with an aluminium heat sink of the claimed invention with 0.5mm thickness. **Figure 9(b)** shows the temperature recorded at the back of the panel without (black) and with (red) the heat sink of the claimed invention with background temperature (blue). **Figure 9(c)** shows the power output curve measured using industry standard instrumentation with (black) and without (red) the heat sink. This demonstrated a 27% increase in output power under the conditions given.

### Optimum design

The important parameters for the natural convection heat sink design are the fin height ***h_{fin}*,** the fin thickness ***t_{fin}*** and the fin spacing ***S***. The fins define air channels of thickness (fin spacing) ***S*,** and the fluid properties, temperature difference and aspect ratio of the problem determine the optimum fin spacing **Sₒₚₜ**. In natural convection there is no external driving force and one must rely on buoyancy to drive the airflow. As such, the balance between buoyancy force and viscous drag is critical and determines the steady state fluid flow. There are several dimensionless parameters which can be used to characterize different regimes of fluid flow. The optimum spacing ***Sₒₚₜ*** can be found analytically for flat plate geometry and is well known from the academic literature (Thermally Optimum Spacing of Vertical, Natural Convection Cooled, Parallel Plates, A. Bar-Choen, and W.M. Rohsenow, Transactions of ASME, 116/Vol. 106, FEBRUARY 1984) [1].

In one embodiment of the present invention, an optimum spacing of 0.8 cm for the 17 cm testbed was preferred, increasing to 1.4 cm for a standard 320W panel of height 1.5 m. A simple fin-type heat sink was chosen to allow simple analytical expression to understand scaling. The fin structure could be made with more complicated cross sections such as those shown in **Figure 4** and this would change the optimum parameters slightly. Fin length, spacing and thickness could be changed as a function of position on a photovoltaic solar panel in order to ensure uniform temperature of the cells in the photovoltaic solar panel, if this is deemed important.

The optimum fin spacing derived above assumes the fins are uniform temperature and are of negligible thickness, so they effectively have very high thermal conductivity. Realistic fin performance will depend on its thermal resistance, and there will be an optimum thickness and length. The optimum fin thickness and length for a specific fin material can be determined using finite element method numerical simulations. These simulations performed by the inventors include heat transfer due to conduction, convection and radiation and a full analysis of the fluid flow.

The optimum fin length ***h_{fin}*** depends on the temperature difference, but also the fin thickness and the material thermal conductivity. Using a high thermal conductivity material or thicker fin allows similar performance to be achieved at a shorter fin length. The inventors used two thicknesses of 0.05 mm and 0.5 mm to demonstrate this for fins made from aluminium and graphite foil, a synthetic high thermal conductive material, as shown in **Figure 11****.** The thinner sample of 0.05 mm is representative of aluminium foil, which has a thickness in this range. The solar panel surface temperature is shown to decrease appreciably up to 50 mm, after which there are little gains. The thicker fin (0.5 mm) represents thin sheet metal which is more rigid. This shows a significantly lower temperature and gains are continued to be observed out to 100mm. In this case, the cost and weight of the aluminium become a factor and the optimum length will need to be decided as a trade-off between cost, weight and performance.

The use of a synthetic graphite foil with a thermal conductivity of 1500W/m/K is almost 8-times more thermally conductive than aluminium and has a lower density. The simulations show a slight improvement with the 0.5 mm thickness case as compared to 0.5 mm of aluminium. However, the more exciting result is that the 0.05 mm graphite film fin still outperforms the 0.5 mm aluminium fin. This graphite film fin is likely to be more expensive than aluminium, however it seems that one could use significantly less material, which would allow a user to save on cost and weight.

Although many different cooling technologies have been proposed in the past, they have not proven economically viable for large scale photovoltaic solar panel farms. The heat sink of the claimed invention can be retrofitted to existing solar panels in order to increase electricity output and prolong the lifetime of the solar panels themselves. The heat sink of the claimed invention can be added post-production to existing back sheet solar panels, or the heat sink itself could serve the function of the back sheet and be integrated at the panel manufacturing stage. The cost of photovoltaic solar panels has decreased by a factor of 10 in the last 5 years. In some arid regions, with high solar irradiance, such as parts of India, solar power generation has become cheaper than fossil fuels. The use of the heat sink of the claimed invention could lower the cost of production even further allowing solar panel farms globally to compete with other renewable and non-renewable power generation technologies.

In the specification the terms "comprise, comprises, comprised and comprising" or any variation thereof and the terms "include, includes, included and including" or any variation thereof are considered to be totally interchangeable and they should all be afforded the widest possible interpretation and vice versa.

The invention is not limited to the embodiments hereinbefore described but may be varied in both construction and detail.

## Claims

1. A heat sink for use with a photovoltaic solar panel unit having a top and a bottom, the heat sink comprising a plurality of fins spaced apart from each other and having a predetermined length, thickness and height, wherein the optimum fin spacing is between about 1 mm and about 50 mm.

2. The heat sink according to Claim 1, wherein the height of the plurality of fins increases in the direction towards the top of the solar panel unit.

3. The heat sink according to Claim 1 or Claim 2, wherein the fins have a thickness of between about 0.01 mm to about 1 mm; having a height at the bottom of the solar panel unit of optionally between about 0.5 cm to about 10 cm; and wherein the fins have a length of optionally between about 10 mm to about 1500 mm.

4. The heat sink according to any one of the preceding claims, wherein the fins are composed of thermally conductive films selected from the group comprising metallic film, a carbon-based film, or polymer films doped with conductive particles or a combination thereof.

5. The heat sink according to Claim 4, wherein the metallic films are selected from films comprising aluminium, copper, stainless steel, tungsten, titanium, or combinations thereof; wherein the carbon-based films are optionally selected from films comprising graphite, pyrolytic graphite, synthetic graphite, graphene, carbon nanotubes, expanded graphite, graphite composites, carbon black, diamond, or combinations thereof; and wherein the conductive particles in the polymer films are optionally selected from a diamond, carbon, transition metal nitrides such as AIN, transition metal oxides such as AlO₃, ceramics such as Si₃N₄, BN or SiC or combinations thereof.

6. The heat sink according to any one of the preceding claims, wherein the plurality of fins are flexible.

7. The heat sink according to any one of the preceding claims, wherein the plurality of fins are coated with an epoxy or polymer; and wherein the polymer is optionally selected from an elastomer, a thermoplastic, a copolymer or combination thereof.

8. The heat sink according to any one of the preceding claims, wherein the fins are made from one continuous sheet of material, or wherein one or more of the plurality of fins are composed of two or more different sheets of material.

9. The heat sink according to any one of the preceding claims, wherein the plurality of fins are applied to the solar panel as a singular unit, or as a series of segmented units.

10. The heat sink according to any one of the preceding claims, wherein air flow through the heat sink is by forced, natural, or passive convection.

11. The heat sink according to any one of the preceding claims, wherein the plurality of fins further comprise a support base; and wherein the support base is optionally mounted individually to each fin.

12. The heat sink according to Claim 11, wherein the support base is opaque, transparent, or a combination thereof.

13. The heat sink according to any one of the preceding claims, wherein the fins have a cross-sectional shape selected from a trapezoid, a sinusoid, a triangle, free-flowing, a square, a circle, a pentagon, a parallelogram, a kite, a crescent, a trefoil, a chevron, a cross, an equiangular shape, columnar, an oblong, an oval, a teardrop, a medallion, a star, a diamond.

14. The heat sink according to any one of the preceding claims, further comprising an airflow isolation means across the width of the plurality of fins.

15. The heat sink according to any one of the preceding claims, further comprising a base plate; wherein the base plate is optionally made from a metal such as aluminium, stainless steel, titanium, copper, tungsten or alloys including these materials; or wherein the base plate is made from a white or transparent material optionally selected from glass, diamond, polymer, quartz, oxides and nitrides of transition metals such as aluminium nitride, aluminium oxide, Titanium Dioxide, and the like.

16. A photovoltaic solar panel geometry comprising the heat sink of Claim 1; wherein the photovoltaic solar panel is either bifacial or monofacial.
